# EUROPEAN PATENT APPLICATION

(11) **EP 4 459 304 A1**
(43) Date of publication of application: **06.11.2024**
(21) Application number: 23171626.7
(22) Date of filing: 04.05.2023
(51) Int. Cl.: G01R 31/40, H02M 1/32

(54) **RECTIFIER AND METHOD OF DETECTING FAULTS IN A RECTIFIER**

(71) Applicant: ABB E-mobility B.V., 2629 JG Delft (NL); ABB SCHWEIZ AG, 5400 Baden (CH)
(72) Inventor: DROFENIK, Uwe, 8053 Zurich (CH)
(74) Representative: Zimmermann & Partner Patentanwälte mbB

(57) **Abstract**

A rectifier including at least two semiconductor devices connected in parallel, a first conductor provided in series with a first one of the at least two semiconductor devices, the first conductor forming a first winding of a coupled inductor, and a second conductor provided in series with a second of the at least two semiconductor devices, the second conductor forming a second winding of the coupled inductor. The first winding and the second winding each include a corresponding number of turns arranged in an antiparallel manner so that magnetic fields generated by the first winding and the second winding in the coupled inductor are mutually opposite when a current flows through the at least two semiconductor devices. The rectifier further includes a third conductor having a first and a second node, wherein the third conductor forms a third winding of the coupled inductor, and an indicator circuit connected to the first and second node. The indicator circuit is configured for indicating a presence of an electrical signal at the first and second node, and for sending a warning signal when powered by a current received by the indicator circuit from the third conductor.

## Description

Aspects of the invention relate to a rectifier having semiconductor devices, such as diodes, connected in parallel. The rectifier may be particularly suitable for use in converters, such as solid state transformers. Aspects of the invention particularly relate to the detection and indication of a faults in the semiconductor devices.

### Technical background:

AC/DC converters, particularly solid state transformers, may be beneficially used in electric vehicle charging, datacenter, marine and/or mining applications, solar and wind power generation, battery storage and/or hydrogen production.

Some converters utilize rectifiers suitable for rectifying e.g. a power received from a medium-voltage grid. A rectifier often includes semiconductor devices, such as diodes, which may be pairwise bundled for redundancy. Beneficially, in case of diode failure, the converter keeps functioning and is still able to deliver nominal power, but the parallel diode, which is now carrying a higher current, experiences a higher current stress.

To prevent further deterioration or even unscheduled downtime, it may be desirable to detect a semiconductor device failure, e.g. to schedule maintenance or replacement of the device. The rectifier may be operating under medium voltage and be insulated from ground, which may complicate fault detection during operation, and may require the rectifier to be unpowered during testing. Detecting a semiconductor device failure may thus not be possible in a safe, simple, quick and/or reliable manner.

The devices and methods provided herein solve the above-stated problem at least in part.

### Summary of the invention

In view of the above, the invention as set out in the appended set of claims is provided.

According to an aspect, a rectifier is described. The rectifier includes at least two semiconductor devices connected in parallel, a first conductor provided in series with a first one of the at least two semiconductor devices, the first conductor forming a first winding of a coupled inductor, and a second conductor provided in series with a second of the at least two semiconductor devices, the second conductor forming a second winding of the coupled inductor. The first winding and the second winding each include a corresponding number of turns arranged in an antiparallel manner so that magnetic fields generated by the first winding and the second winding in the coupled inductor are mutually opposite when a current flows through the at least two semiconductor devices. The rectifier further includes a third conductor having a first and a second node, wherein the third conductor forms a third winding of the coupled inductor, and an indicator circuit connected to the first and second node. The indicator circuit is configured for indicating a presence of an electrical signal at the first and second node, and for sending a warning signal when powered by a current received by the indicator circuit from the third conductor.

According to an aspect, a method of detecting faults in a rectifier is described. The rectifier includes at least two semiconductor devices connected in parallel. The method includes generating a first magnetic field having a field strength proportional to a first electric current flowing through a first one of the at least two semiconductor devices in a coupled inductor, and generating a second magnetic field having a field strength proportional to a second electric current flowing through a second one of the at least two semiconductor devices in the coupled inductor. The first magnetic field is mutually opposite the second magnetic field when a current flows through the at least two semiconductor devices. The method further includes inducing a voltage in a conductor forming a winding of the coupled inductor, and generating a signal proportional to the induced voltage. The signal is indicative of an asymmetry between the first electric current and the second electric current. The method further includes, based on the signal, generating a warning signal by an indicator circuit powered by a current received from the conductor.

According to an aspect, a rectifier is described. The rectifier may be configured for rectifying a medium voltage, particularly an AC voltage, such as a voltage received from a medium-voltage grid, e.g. at 50 Hz or 60 Hz. The voltage may be received directly from a grid or a medium voltage power source, and/or may be received from an intermediate electrical or electronic device. A medium voltage as described herein may be considered a voltage of 1 Kilovolt (kV) to 50 kV, particularly 10 kV to 30 kV. The rectifier described herein may be equally suitable for rectifying a low voltage. A low voltage as described herein may be considered a voltage of 200 V to 2 kV, such as a voltage at approximately 1.7 kV.

According to an aspect, the rectifier is configured for rectifying a voltage of at least 3 kV, at least 5 kV, at least 10 kV, at least 20 kV, or even at least 30 kV. According to an aspect, the rectifier is configured for rectifying a power of at least 500 Kilowatt (kW), at least 1 MW, at least 2 MW, at least 5 MW, or even at least 10 MW.

According to an aspect, the rectifier may be directly connected to the medium voltage, and/or be connected to the medium voltage with no galvanic insulation. Beneficially, electronic devices, such as converters, such as solid state transformers, including a rectifier according to aspects and/or embodiments described herein, may be provided without a distribution transformer provided between the medium voltage and the rectifier, which may reduce the cost and/or footprint of the electronic device. Galvanic insulation of the output power of the electronic device may be provided e.g. by a medium-frequency transformer, which may be provided after a switching stage configured for switching a DC power provided by the rectifier.

According to an aspect, the rectifier may include a plurality of semiconductor devices. In the embodiments described herein, the semiconductor devices may be depicted and/or described as diodes, particularly semiconductor diodes such as silicon diodes, however, different types of semiconductor devices, such as switchable semiconductor devices may be provided. For example, the rectifier may include actively switchable semiconductor devices, such as transistors and/or thyristors, such as a metal-oxide-semiconductor field-effect transistor (MOSFET), an insulated-gate bipolar transistor (IGBT), high-electron-mobility transistor (HEMT), or an integrated gate-commutated thyristor (IGCT).

According to an aspect, the plurality of semiconductor devices may be arranged to rectify an AC voltage, particularly one or more phases of an AC voltage. For example, the semiconductor devices may be included in one or more bridge rectifier circuits, such as diode bridges, according to the knowledge of the skilled person at the time of filing of this disclosure.

According to an aspect, the plurality of semiconductor devices includes at least two semiconductor devices connected in parallel. The two semiconductor devices may functionally form a single semiconductor device in the rectifier. For example, two diodes may be connected in parallel to functionally operate as a single diode in the rectifier. Beneficially, in case a first one of the diodes fails in an open state, the current may flow through a second one of the diodes.

According to an aspect, the rectifier may include at least two semiconductor devices connected in series. In particular, the plurality of semiconductor devices may include at least two semiconductor devices connected in series. The at least two semiconductor devices connected in series may functionally form a single semiconductor device, and/or may functionally form a portion of a single semiconductor device, in the rectifier. For example, the two semiconductor devices connected in series may be connected in parallel to further semiconductor devices connected in series, so that a single functional semiconductor device, such as a single functional diode, is formed by the serially connected semiconductor devices connected in parallel. Connecting at least two semiconductor devices in parallel may beneficially increase the voltage rating of the devices. For example, a rectifier may be configured for rectifying a medium voltage by providing a plurality of low voltage semiconductor devices connected in series. Beneficially, connecting the semiconductor devices in series may provide redundancy in case one or more of the semiconductor devices fails in a closed state.

Further advantages, features, aspects and details that can be combined with embodiments described herein are evident from the dependent claims, the description and the drawings.

### Brief description of the Figures:

### The details will be described in the following with reference to the figures, wherein

- Fig. 1A: shows a schematic circuit diagram of semiconductor devices in a rectifier according to embodiments;
- Fig. 1B: shows a schematic circuit diagram of semiconductor devices in a rectifier according to embodiments;
- Fig. 2A: shows a schematic configuration of an inductor according to embodiments;
- Fig. 2B: shows a schematic configuration of an inductor according to embodiments;
- Fig. 2C: shows a schematic configuration of an inductor according to embodiments;
- Fig. 3: shows a graph displaying the operation of an indicator circuit according to embodiments;
- Fig. 4: shows a schematic circuit diagram of a rectifier according to embodiments; and
- Fig. 5: shows a method of detecting faults in a rectifier according to embodiments.

### Detailed description of the Figures and of embodiments:

Reference will now be made in detail to the various embodiments, one or more examples of which are illustrated in each figure. Each example is provided by way of explanation and is not meant as a limitation. For example, features illustrated or described as part of one embodiment can be used on or in conjunction with any other embodiment to yield yet a further embodiment. It is intended that the present disclosure includes such modifications and variations.

Within the following description of the drawings, the same reference numbers refer to the same or to similar components. Generally, only the differences with respect to the individual embodiments are described. Unless specified otherwise, the description of a part or aspect in one embodiment applies to a corresponding part or aspect in another embodiment as well.

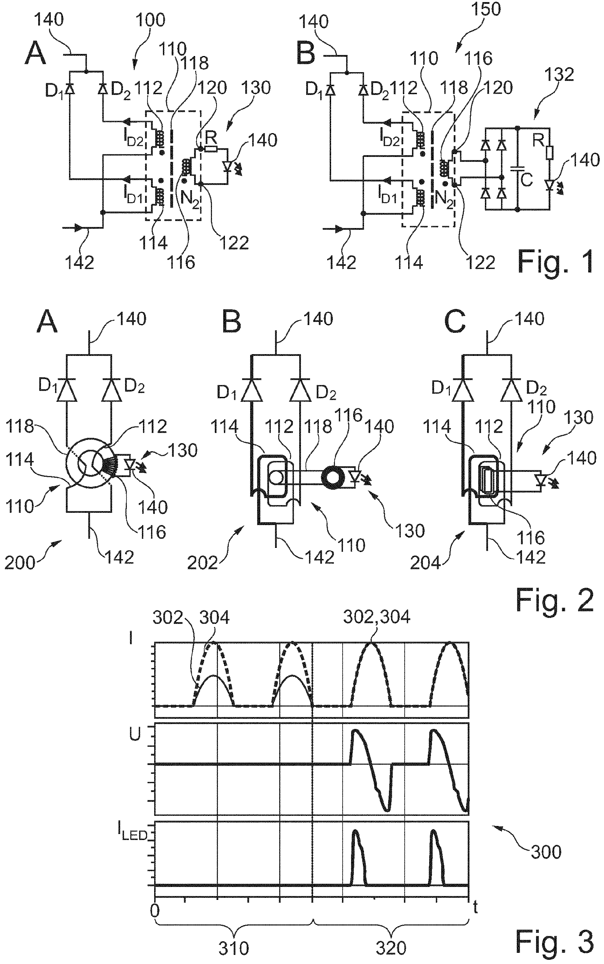

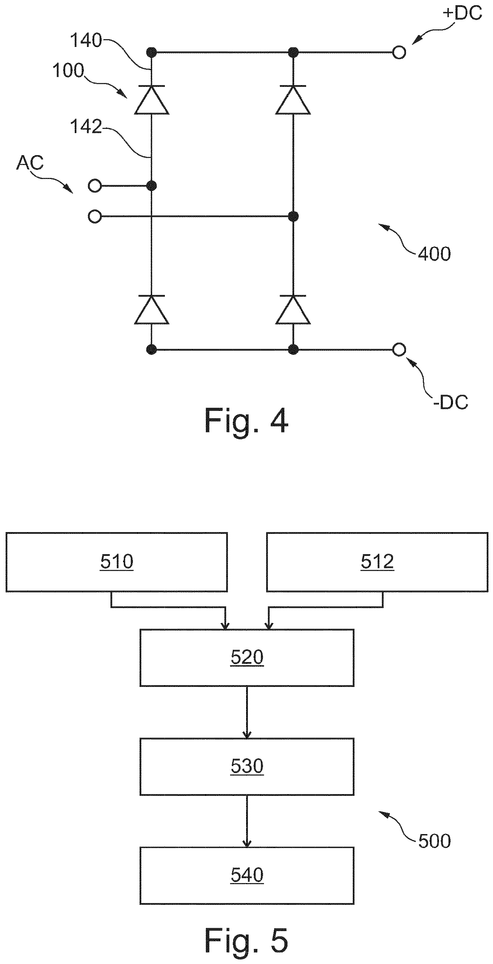

Fig. 1A and Fig. 1B show diagrams of the circuits 100, 150. The circuits 100, 150 include two semiconductor devices, diodes D₁ and D₂, which may be provided in a rectifier according to embodiments. The rectifier may be the rectifier 400 as shown in Fig. 4. The diodes D₁ and D₂ are connected in parallel, and may functionally operate as a single diode in the rectifier. The circuit 100, 150 may be configured to operate as a diode in the rectifier, and be connected to functionally represent a diode between the conductors 140 and 142 connected to and/or included in the rectifier.

Each diode D₁ and D₂ has a conductor provided in series with the diode. During operation of the rectifier, the first current I_{D1} flows through the first conductor and the first diode D₁, and the second current I_{D2} flows through the second conductor and the second diode D₂. During normal operation of the rectifier, the current I_{D1} may be essentially identical in magnitude to the current I_{D2}. In case one of the diodes D₁ and D₂ fails, particularly in an open state, the current I_{D1} may differ from the current I_{D2}.

The circuits 100, 150 include an inductor 110. The inductor 110 may include a core 118, such as a core as described herein with reference to Fig. 2. The inductor includes a first winding 112 and a second winding 114. The first winding 112 and the second winding 114 are formed by the conductors provided in series with the diode.

The first winding 112 and the second winding 114 each include a corresponding number of turns arranged in an antiparallel manner, particularly in a symmetrical manner. When an electric current flows through the first conductor and/or the second conductor, the first winding 112 and/or the second winding 114 generate a magnetic field in the inductor 110. For example, the magnetic field may magnetize the core 118 of the inductor. The first winding 112 and the second winding 114 are arranged in the circuit 110, 115 so that magnetic fields generated by the first winding 112 and the second winding 114 are mutually opposite when a current flows though the diodes D₁ and D₂, and/or when a current flows from the conductor 142 to the conductor 140. In particular, the first winding 112 and the second winding 114 may generate magnetic fields that mutually cancel each other in the inductor 110 in when the current I_{D1} and the current I_{D2} are the same. In case the current I_{D1} is higher or lower than the current I_{D2}, the magnetic fields generated by the windings 112, 114 may cancel each other partially and/or not cancel each other fully. In case one of the currents I_{D1} or I_{D2} is zero, the inductor 110 may be magnetized according to the current I_{D1} or I_{D2} that is not zero.

The circuit 100, 150 includes a third conductor defining a first node 120 and a second node 122. The nodes 120, 122 may be connectors and/or terminals. Additionally, or alternatively, the nodes 120, 122 may be connected to an indicator circuit 130, 132, e.g. directly via conductors, or by being connected to the connectors and/or terminals. The third conductor forms a third winding 116 of the inductor 110.

The inductor 110 is a coupled inductor. In particular, the first winding 112, the second winding 114 and the third winding 116 are inductively coupled in the inductor 110 and/or by the inductor 110.

A magnetic field generated by the first winding 112 and/or the second winding 114 may induce a voltage in the third conductor 116. In case the magnetic fields generated by the first winding 112 and the second winding 114 cancel each other, no voltage may be induced in the third winding 116.

The circuits 100, 150 include an indicator circuit 130, 132 connected to the first node 120 and the second node 122. The indicator circuit 130, 132 is configured for indicating a presence of an electrical signal at the first node 130 and the second node 132. In particular, the electrical signal may be a voltage, current and/or power, particularly a voltage, current and/or power induced in the third winding 116 by a magnetic field in the inductor 110. According to embodiments, a current asymmetry between the current I_{D1} within the first conductor and the current I_{D2} within the second conductor induces a voltage between the first and the second node 120, 122 of the third conductor. Accordingly, the electrical signal may include the induced voltage.

The indicator circuit 130, 132 is configured for sending a warning signal when powered by a current received by the indicator circuit 130, 132 from the third conductor. In particular, the indicator circuit 130, 132 may be configured for being powered by a voltage, current and/or power received from the third conductor, such as the electrical signal. Beneficially, the indicator circuit 130, 132 may be independent from and/or devoid of external power sources.

According to embodiments, the warning signal may be a wireless warning signal, such as warning signal transmittable and/or detectable without a galvanic connection to the indicator circuit 130, 132 or even the rectifier.

An indicator circuit 130 according to a first embodiment is shown in Fig. 1A. The indicator circuit includes a light-emitting diode (LED) 140 connected to the nodes 120, 122 through a serially connected current limiting resistor R. The current limiting resistor may be dimensioned according to the expected voltage of the electrical signal between the nodes 120, 122, and/or the internal resistance of the indicator circuit, and may be optional in some embodiments. In case an AC voltage is induced in the third winding 116, each half-wave of the AC voltage flowing in the forward direction of the LED 140 will illuminate the LED 140. Light emitted by the LED 140 may be a warning signal.

Referring now to Fig. 1B, a circuit 150 having an indicator circuit 132 according to a second embodiment is shown. Only the differences with respect to the indicator circuit 130 will be explained. In addition to the indicator circuit 130, a bridge rectifier having four diodes is provided for rectifying a signal received from the third winding 116 and/or the nodes 120, 122. Furthermore, a smoothing capacitor C is provided in parallel to the output of the bridge rectifier. In case an AC voltage is induced in the third winding 116, the AC voltage is rectified and smoothed. Accordingly, the indicator circuit 132 may beneficially provide a more stable and/or stronger warning signal.

According to embodiments, several circuits 100, 150 may be provided in the rectifier, such as for a plurality or even all functional diodes within the rectifier. Accordingly, several indicator circuits configured for generating several warning signals may be provided. Accordingly, the location of the fault may be identifiable based on the warning signal associated with the fault.

While the indicator circuits 130, 132 were described as including LEDs 140, other or additional light emitting devices, such as incandescent light sources, gas discharge light sources, glow lamps or the like may be utilized in some embodiments. The light signal generated by the light emitting device may be a warning signal. The light emitting device may be provided in the rectifier such that the warning signal is visible and/or detectable during operation of the rectifier, e.g. at an edge of a PCB, close to a transparent or open portion of a housing including the rectifier, or optically coupled, e.g. via an optical fiber, to an outside portion of the housing. For example, the light signal may be visible by a service technician, e.g. during optical inspection, even from a safe distance and/or while the rectifier is operating. Likewise, the warning signal may be detected by a detector, such as a detection circuit and/or a detection apparatus.

In a first example, the light emitting device and the detector may form a portion of an optocoupler. Beneficially, the detector may be provided galvanically insulated from the rectifier. In some embodiments, the light emitting device and the detector may be communicatively connected by an optical fiber for transmitting the warning signal from the light emitting device to the detector.

In a second example, the detector may include an imaging device, such as a camera, and an image processing and/or recognition system. The imaging device may be configured for imaging and monitoring the rectifier and/or the light emitting devices, and preferably recognizing the presence of a warning signal in the image. For example, the detector may be configured for a continuous and automatic postprocessing of the image, and utilize an image recognition algorithm, such as a deep neural network based algorithm, to detect the presence of a warning signal, and even identify a fault based on the location of the warning signal. Likewise, the image may be transmittable to a remote screen, and be detectable by a technician.

While the indicator circuits 130, 132 have been described as generating an optical warning signal, i.e. a light signal, other and/or further signal types may be equally suitable.

According to an embodiment, the warning signal may be an acoustic signal. For example, the indicator circuit may include a sound emitter, such as a buzzer, to generate an audible warning signal.

According to an embodiment, the warning signal may be an electric signal. For example, the indicator circuit may include a further inductive coupling, such as a second inductor, to galvanically isolate the electrical signal, and provide a galvanically insulated warning signal, which may beneficially be provided to a (grounded) detector.

Referring now to Fig. 2A, 2B and 2C, aspects of an inductor 110 according to embodiments are described. The inductor 110 is provided in the circuits 200, 202 and 204. According to embodiments, portions of the circuits 200, 202, and 204, particularly the at least two semiconductor devices, the coupled inductor 110, and/or the indicator circuit may be provided on a printed circuit board (PCB). Likewise, some or all of the components of a rectifier according to embodiments may be provided on the PCB. According to embodiments, the PCB may form a rectifier and/or a portion of a rectifier, such as a rectifier module, of a solid state transformer. In particular, the PCB may be operated at a medium voltage.

Fig. 2A, 2B and 2C schematically show possible implementations and/or layouts of the diodes D₁, D₂, the inductor 110 and the indicator circuit 130 being provided on a PCB. The circuits 200, 202 and/or 204 may be implementations of the circuits 100, 105 shown in Fig. 1A or Fig. 1B.

In Fig. 2A, the inductor 110 includes a toroidal core 118 being provided on a PCB. The PCB extends along the drawing plane. The first conductor and the second conductor are partially formed by conductive elements, such as traces, within the PCB. The first winding 112 and the second winding 114 are formed partially by PCB traces, as indicated by the dotted portion of the conductors, and by wires routed through and above the toroidal core. Accordingly, the first winding 112 and the second winding 114 include a single turn. Likewise, according to embodiments, additional turns may be added, e.g. by forming additional turns by the wires, such as two or more turns, three or more turns, 5 or more turns, or even 10 or more turns. Additional turns of the windings may increase the magnetization of the core and thus the signal strength of the electrical signal induced in the third winding 116. Preferably, the number of turns in the first winding 112 and the second winding 114 may be low to reduce losses, such as resistive and/or inductive losses.

As shown in Fig. 2A, a third conductor is provided, the third conductor including the third winding 116. The third winding 116 may be wound on the toroidal core 118. The third winding 116 may include a number of turns that is higher than the number of turns of the first winding 112 and/or the second winding 114. In particular, the third winding may have at least two times, at least 5 times, at least 10 times or even at least 20 times as many turns as the first and/or second winding. For example, the third winding may include two or more turns, 5 or more turns, 10 or more turns, or even 20 or more turns.

As schematically shown in Fig. 2A, an indicator circuit 130 including e.g. an LED 140 may be connected to the third conductor. Additionally, or alternatively, other types of indicator circuits according to aspects and/or embodiments described herein may be provided.

In Fig. 2B, the inductor 110 includes a gapped core 118 being provided through holes within the PCB (not shown). In Fig. 2B, the gapped core 118 is shown in a cutaway along a plane parallel to the drawing plane and/or plane of the PCB. As shown in Fig. 2B, the gapped core 110 may be, particularly when assembled, a toroidal and/or toroid-like core. Likewise, the core 110 may be an E-core, an EI-core, a U-core, a UI core, a planar core, or a DG core. The first winding 112 and the second winding 114 are formed essentially by traces within the PCB. Overlapping traces may include wire bridges, or multilayer PCB structures.

As shown in Fig. 2B, the third winding 116 may include a wire wound around the core 118, such as a leg of the core. Likewise, the third winding may be implemented as one or more traces within the PCB, e.g. as traces within a multilayer PCB structure.

According to embodiments, the core 118 shown in Fig. 2A and/or Fig. 2B may be a ferrite core, such as a powdered core, or any other type of magnetic core known at the time of filing this disclosure.

In Fig. 2C, the inductor 110 includes an air core. Accordingly, the inductor 110 does not include a magnetic core. The first winding 112, the second winding 114 and the third winding 116 are provided as traces within a multilayer PCB.

Referring now to Fig. 3, a graph 300 demonstrating the generation of a warning signal in a fault state by a rectifier according to embodiments, such as the rectifier including the circuit 100, is shown.

Line 302 indicates the current flowing through a first diode and a first inductor, such as the current I_{D1} flowing through diode D₁. Line 304 shows the total current flowing through conductors 140 and/or 142. In the example, line 304 represents the sum of the currents I_{D1} and I_{D2}.

Section 310 of the graph 300 shows the rectifier operating in a normal state, such as when both diodes D₁ and D₂ operate normally, where I_{D1}=I_{D2}. Section 320 of the graph 300 shows the rectifier operating with a faulty diode D₂, such that I_{D1}+I_{D2}=I_{D1}.

The graph 300 shows the voltage U measurable between the nodes 120, 122. The graph 300 further shows the current I_{LED} flowing through the LED 140. During normal operation, the currents I_{D1} and I_{D2} in the first conductor and the second conductor generate mutually opposite magnetic fields. Accordingly, no voltage or current is induced in the third winding 116. When one of the diodes fails, only the magnetic field of the second winding 114 is present, and the magnetic field is not cancelled out by the first winding 112. Accordingly, an electric signal, having a voltage U and causing a current I_{LED} to flow through the LED 140 is present at the nodes 120, 122. Accordingly, a light signal being a warning signal is generated by the LED 140 in the fault state.

In the examples shown herein, two semiconductor devices connected in parallel were described. According to embodiments, additional semiconductor devices may be provided in the circuit 100, 150. For example, the semiconductor devices may be an even number of semiconductor devices, such as 4, 6, 8 or even more than 8 semiconductor devices connected in parallel. Windings such as the first winding and the second winding may be provided in the inductor so that, when the semiconductor devices operate normally, the magnetic fields generated by the winding essentially cancel each other.

According to embodiments, the inductor 110 and the indicator circuit 130, 132 may be utilized for detecting faults in more than one semiconductor pair, such as the diode pair D₁ and D₂. For example, the windings associated with a first semiconductor pair connected in parallel, and the windings associated with a second semiconductor pair connected in parallel, and/or even a third, and/or even a fourth semiconductor pair, may be provided on the same inductor. Accordingly, a single inductor 110 and a single indicator circuit 130, 132 may be utilized to detect faults in several semiconductor devices of the rectifier.

Referring now to Fig. 4, a rectifier 400 according to embodiments is shown. The rectifier 400 includes four functional diodes connected in a full-wave single phase bridge rectifier configuration to rectify an AC power into a +DC, -DC power. As shown in Fig. 4, one or more, or even all of the functional diodes may include a circuit according to embodiments described herein, such as the circuit 100, or the circuit 150 shown in Fig. 1. While the rectifier 400 is shown as a single-phase rectifier, other configurations, such as three-phase or even multi-pulse rectifiers, may be equally suitable.

Referring now to Fig. 5, a method 500 of detecting faults in a rectifier is described. The rectifier may be a rectifier according to embodiments described herein, such as the rectifier 400. The rectifier includes at least two semiconductor devices connected in parallel, e.g. between the conductors 140 and 142 shown in Fig. 1A, Fig. 1B or Fig. 4.

The method includes generating 510 a first magnetic field having a field strength proportional to a first electric current flowing through a first one of the at least two semiconductor devices in a coupled inductor, and generating 512 a second magnetic field having a field strength proportional to a second electric current flowing through a second one of the at least two semiconductor devices in the coupled inductor.

According to embodiments, generating the first magnetic field and/or the second magnetic field may include providing windings of the inductor, e.g. by forming windings within and/or by the first conductor and the second conductor.

The first magnetic field is mutually opposite the second magnetic field when a current flows though the at least two semiconductor devices. In particular, a current flowing through each of the semiconductor devices having essentially the same magnitude may generate two mutually opposite magnetic fields, such that the sum of the two magnetic fields results in an essentially net-zero magnetic field within the inductor.

The method 500 includes inducing 520 a voltage in a conductor forming a winding of the coupled inductor. The winding may be a third winding 116 as shown in Fig. 1 and/or Fig. 2. It should be noted that a zero voltage may be understood as a voltage, the zero voltage indicating a normal, i.e. a non-fault state of the rectifier.

The method 500 includes generating 530 a signal proportional to the induced voltage. The signal may include a voltage, a current and/or a power. The signal may be the electrical signal present at and/or measurable at the nodes 120, 122. The signal is indicative of an asymmetry between the first electric current and the second electric current. Accordingly, in case the first electric current and the second electric current are identical in magnitude, the signal may be 0. In case of an asymmetry between the first electric current and the second electric current, the signal may be a voltage U as shown in section 320 of the graph 300.

According to embodiments, the method may include utilizing the signal to power the indicator circuit. According to further embodiments, the signal may power additional circuits, such as additional active sensors within the rectifier.

The method 500 includes generating 540 a warning signal by an indicator circuit. The warning signal is based on the signal. The indicator circuit is powered by a current received from the conductor. As shown in e.g. Fig. 3, the signal may include a voltage suitable for causing a current to flow within the indicator circuit, such as a current flowing through an LED. Accordingly, the method may include not providing an external power to the indicator circuit. Beneficially, the warning signal may be a wireless warning signal, particularly an optical and/or acoustic signal detectable from a distance and/or without requiring a galvanic connection to the rectifier.

According to embodiments, the method 500 may include generating a normal-state signal. The normal state signal may be defined as the absence of the warning signal. According to embodiments, the warning signal may be indicative of one, or even more than one, semiconductor devices being in a fault state. In a typical embodiment, the fault state includes an open state. Likewise, in some embodiments, the fault state may include one of the semiconductor devices being in a closed state.

According to embodiments, the method 500 may include detecting the warning signal with a galvanically insulated detector, such as a detector galvanically insulated from the rectifier and/or the indicator circuit. The detector may be a detector as described with reference to Fig. 1.

According to an aspect, a galvanically insulated detector may further comprise a network interface for connecting the device to a data network, in particular a global data network. The data network may be a TCP/IP network such as Internet. The galvanically insulated detector is operatively connected to the network interface for carrying out commands received from the data network. The commands may include a control command for controlling the galvanically insulated detector to carry out a task such as monitoring the rectifier for the presence of a warning signal. In this case, the galvanically insulated detector is adapted for carrying out the task in response to the control command. The commands may include a status request. In response to the status request, or without prior status request, the galvanically insulated detector may be adapted for sending a status information to the network interface, and the network interface is then adapted for sending the status information over the network. The commands may include an update command including update data. In this case, the galvanically insulated detector is adapted for initiating an update in response to the update command and using the update data."

The data network may be an Ethernet network using TCP/IP such as LAN, WAN or Internet. The data network may comprise distributed storage units such as Cloud. Depending on the application, the Cloud can be in form of public, private, hybrid or community Cloud.

The solutions proposed herein beneficially allow an efficient detection of faults in a rectifier which may be connected without galvanic insulation to a medium voltage source. Beneficially, the solution may be simple and easy to implement at low cost. Beneficially, the proposed solutions may provide negligible power losses. Beneficially, no additional power, such as an external power source, is required for powering the indicator circuit. Beneficially, a fault may be efficiently located based on the warning signal, and the faulty semiconductor device may be easily identified. Beneficially, no additional medium voltage insulation is required within the rectifier, particularly between the semiconductor devices and the indicator circuit.

## Claims

1. A rectifier comprising:
at least two semiconductor devices connected in parallel;
a first conductor provided in series with a first one of the at least two semiconductor devices, wherein the first conductor forms a first winding of a coupled inductor;
a second conductor provided in series with a second of the at least two semiconductor devices, wherein the second conductor forms a second winding of the coupled inductor; wherein
the first winding and the second winding each comprise a corresponding number of turns arranged in an antiparallel manner so that magnetic fields generated by the first winding and the second winding in the coupled inductor are mutually opposite when a current flows through the at least two semiconductor devices;
a third conductor having a first and a second node, wherein the third conductor forms a third winding of the coupled inductor; and
an indicator circuit connected to the first and second node, wherein the indicator circuit is configured for indicating a presence of an electrical signal at the first and second node, and for sending a warning signal when powered by a current received by the indicator circuit from the third conductor.

2. The rectifier according to claim 1, wherein a current asymmetry between the current within the first conductor and the current within the second conductor induces a voltage between the first and the second node of the third conductor, the electrical signal comprising the voltage.

3. The rectifier according to claim 1 or 2, wherein each of the at least two semiconductor devices comprises at least one diode.

4. The rectifier according to any one of the preceding claims, wherein each of the at least two semiconductor devices comprises at least one switchable device, particularly a thyristor and/or a transistor.

5. The rectifier according to any one of the preceding claims, wherein the rectifier further comprises at least two semiconductor devices connected in series.

6. The rectifier according to any one of the preceding claims, wherein the rectifier is configured for rectifying voltage of at least 3 kV.

7. The rectifier according to any one of the preceding claims, wherein the indicator circuit comprises a light-emitting device, particularly a light emitting diode.

8. The rectifier according to any one of the preceding claims, wherein the indicator circuit comprises a sound emitter.

9. The rectifier according to any one of the preceding claims, wherein the coupled inductor comprises an air core, a toroidal inductor core, and/or a gapped core.

10. The rectifier according to any one of the preceding claims, wherein the at least two semiconductor devices and the coupled inductor are provided on a printed circuit board, PCB.

11. Method of detecting faults in a rectifier, the rectifier comprising at least two semiconductor devices connected in parallel; the method comprising:
generating a first magnetic field having a field strength proportional to a first electric current flowing through a first one of the at least two semiconductor devices in a coupled inductor;
generating a second magnetic field having a field strength proportional to a second electric current flowing through a second one of the at least two semiconductor devices in the coupled inductor, wherein
the first magnetic field is mutually opposite the second magnetic field when a current flows through the at least two semiconductor devices;
inducing a voltage in a conductor forming a winding of the coupled inductor;
generating a signal proportional to the induced voltage, wherein the signal is indicative of an asymmetry between the first electric current and the second electric current;
based on the signal, generating a warning signal by an indicator circuit powered by a current received from the conductor.

12. The method according to claim 11, further comprising: detecting the warning signal with a galvanically insulated detector.

13. The method according to claim 11 or 12, wherein the warning signal is an optical signal.

14. The method according to any one of claims 11 to 13, wherein the warning signal is an acoustic signal.

15. The method according to any one of claims 11 to 14, wherein the warning signal is indicative of one of the at least two semiconductor devices being in a fault state, and particularly wherein the fault state includes the semiconductor device being in an open state.
